# EUROPÄISCHE PATENTSCHRIFT

(11) **EP 2 510 558 B1**
(45) Veröffentlichungstag und Bekanntmachung des Hinweises auf die Patenterteilung: **26.06.2019**
(21) Anmeldenummer: 10788035.3
(22) Anmeldetag: 17.11.2010
(51) Int. Cl.: H01L 33/56, H01L 33/50

(54) **OPTOELEKTRONISCHES HALBLEITERBAUTEIL**
OPTOELECTRONIC DEVICE
DISPOSITIF OPTOELECTRONIQUE

(30) Priorität: 11.12.2009 DE 102009058006
(43) Veröffentlichungstag der Anmeldung: 17.10.2012
(73) Patentinhaber: OSRAM Opto Semiconductors GmbH, 93055 Regensburg (DE)
(72) Erfinder: KRÄUTER, Gertrud, 93051 Regensburg (DE); BARCHMANN, Bernd, 93059 Regensburg (DE); BERGENEK, Krister, 93059 Regensburg (DE); RAMCHEN, Johann, 84032 Altdorf (DE); ZITZLSPERGER, Michael, 93047 Regensburg (DE)
(74) Vertreter: Epping - Hermann - Fischer
(86) Internationale Anmeldenummer: PCT/EP2010/067707
(87) Internationale Veröffentlichungsnummer: WO 2011/069791

(56) Entgegenhaltungen:
- EP-A1- 2 216 834
- EP-A1- 2 216 834
- WO-A2-2009/048704
- WO-A2-2009/115998
- DE-A1-102008 025 923
- US-A1- 2009 166 657

## Beschreibung

Es wird ein optoelektronisches Halbleiterbauteil angegeben. Diese Patentanmeldung beansprucht die Priorität der deutschen Patentanmeldung 10 2009 058 006.9.

Eine zu lösende Aufgabe besteht darin, ein optoelektronisches Halbleiterbauteil anzugeben, bei dem Strahlungsverluste besonders gering sind und dessen Strahlungsaustrittsfläche besonders hell erscheint.

WO 2009/069671 A1 oder WO 2009/115998 A2 offenbart ein optoelektronisches Halbleiterbauteil, aufweisend zumindest einen strahlungsemittierenden Halbleiterchip mit einer Strahlungsauskoppelfläche, durch die zumindest ein Teil der im Halbleiterchip erzeugten elektromagnetischen Strahlung den Halbleiterchip verlässt; zumindest ein Konverterelement, das dem Halbleiterchip an seiner Strahlungsauskoppelfläche zur Konversion von vom Halbleiterchip emittierter elektromagnetischer Strahlung nachgeordnet ist und eine der Strahlungsauskoppelfläche abgewandete erste Oberfläche aufweist; eine reflektierende Umhüllung, wobei die reflektierende Umhüllung den Halbleiterchip und das Konverterelement an Seitenflächen formschlüssig umhüllt und die erste Oberfläche des Konverterelements frei von der reflektierenden Umhüllung ist.

Die vorliegende Erfindung bezieht sich auf ein optoelektronisches Halbleiterbauteil nach dem Anspruch 1. Weitere Ausführungsformen der Erfindung gehen aus den Unteransprüchen hervor.

Gemäß zumindest einer Ausführungsform des optoelektronischen Halbleiterbauteils weist das Bauteil zumindest einen strahlungsemittierenden Halbleiterchip mit einer Strahlungsauskoppelfläche auf. Durch die Strahlungsauskoppelfläche verlässt zumindest ein Teil der im Halbleiterchip erzeugten elektromagnetischen Strahlung den Halbleiterchip. Bei dem strahlungsemittierenden Halbleiterchip kann es sich beispielsweise um einen Lumineszenzdiodenchip handeln. Bei dem Lumineszenzdiodenchip kann es sich um einen Leucht- oder Laserdiodenchip handeln, der Strahlung im Bereich von ultraviolettem bis infrarotem Licht emittiert. Vorzugsweise emittiert der Lumineszenzdiodenchip Licht im sichtbaren oder ultravioletten Bereich des Spektrums der elektromagnetischen Strahlung. Gemäß zumindest einer Ausführungsform des Halbleiterbauteils weist das Bauteil zumindest ein Konverterelement auf, das dem Halbleiterchip an seiner Strahlungsauskoppelfläche zur Konversion von vom Halbleiterchip emittierter elektromagnetischer Strahlung nachgeordnet ist. Das zumindest eine Konverterelement weist eine der Strahlungsauskoppelfläche abgewandte erste Oberfläche auf. Ferner ist das zumindest eine Konverterelement dem Halbleiterchip derart nachgeordnet, dass zumindest ein Teil der im Betrieb des Halbleiterchips erzeugten elektromagnetischen Strahlung in das Konverterelement gelangt. Beispielsweise wandelt das Konverterelement vom Halbleiterchip emittierte elektromagnetische Strahlung in Strahlung größerer Wellenlänge um. Beispielsweise ist das zumindest eine Konverterelement auf die Strahlungsauskoppelfläche des zumindest einen Halbleiterchips aufgebracht und kann mittels eines Verbindungsmittels mit dieser verbunden sein.

Gemäß zumindest einer Ausführungsform weist das optoelektronische Halbleiterbauteil eine reflektierende Umhüllung auf. "Reflektierend" heißt in diesem Zusammenhang, dass die Umhüllung für aus dem Halbleiterchip und/oder dem Konverterelement auf sie auftreffende elektromagnetische Strahlung zumindest zu 80 %, bevorzugt zu mehr als 90 %, reflektierend ist. Bei der reflektierenden Umhüllung kann es sich um eine Schicht handeln, die auf Außenflächen des Halbleiterchips und des Konverterelements aufgebracht ist. Ebenso ist denkbar, dass die Umhüllung ein Verguss ist, der beispielsweise durch Vergießen des Halbleiterchips und des Konverterelements aufgebracht ist.

Gemäß zumindest einer Ausführungsform umhüllt die reflektierende Umhüllung den Halbleiterchip und stellenweise das Konverterelement an Seitenflächen formschlüssig. Beispielsweise verlaufen die Seitenflächen des Halbleiterchips und des Konverterelements in einer vertikalen Richtung, also senkrecht oder quer zu einer epitaktisch gewachsenen Halbleiterschichtenfolge des strahlungsemittierenden Halbleiterchips. "Formschlüssig umhüllt" heißt in diesem Zusammenhang, dass die reflektierende Umhüllung den Halbleiterchip und stellenweise das Konverterelement an den Seitenflächen umgibt und mit diesen in direktem Kontakt steht. Mit anderen Worten bildet sich vorzugsweise zwischen der reflektierenden Umhüllung und den Seitenflächen weder ein Spalt noch eine Unterbrechung aus. "Zumindest stellenweise" kann dabei bedeuten, dass die reflektierende Umhüllung, beispielsweise ein Verguss, die Seitenflächen des Konverterelements nur bis zu einer gewissen Füllhöhe formschlüssig umhüllt. Dadurch ist es möglich, dass der Halbleiterchip selbst an seinen Seitenflächen durch die reflektierende Umhüllung vollständig verdeckt ist, wobei das Konverterelement aus der reflektierenden Umhüllung noch herausragt. Es sind also die Seitenflächen des Konverterelements bis zu einer vorgebbaren Höhe teilweise von der reflektierenden Umhüllung bedeckt. Gemäß zumindest einer Ausführungsform ist die erste Oberfläche des Konverterelements frei von der Umhüllung. "Frei" heißt, dass die erste Oberfläche weder von der reflektierenden Umhüllung bedeckt ist noch die reflektierende Umhüllung entlang des Strahlungsaustrittswegs des Halbleiterbauteils dem Konverterelement nachgeordnet ist. Die Strahlung kann daher ungehindert aus dem Konverterelement austreten. Es ist höchstens möglich, dass herstellungsbedingt sich noch Materialreste der reflektierenden Umhüllung auf der ersten Oberfläche befinden, die die erste Oberfläche jedoch zu höchstens 10 %, bevorzugt zu höchstens 5 %, bedecken.

Gemäß zumindest einer Ausführungsform des optoelektronischen Halbleiterbauteils weist dieses zumindest einen strahlungsemittierenden Halbleiterchip mit einer Strahlungsauskoppelfläche auf, durch die zumindest ein Teil der im Halbleiterchip erzeugten elektromagnetischen Strahlung den Halbleiterchip verlässt. Weiter ist dem Halbleiterchip an seiner Strahlungsauskoppelfläche zur Konversion von vom Halbleiterchip emittierter elektromagnetischer Strahlung ein Konverterelement nachgeordnet. Das Konverterelement weist eine der Strahlungsauskoppelfläche abgewandte Oberfläche auf. Ferner weist das optoelektronische Halbleiterbauteil eine reflektierende Umhüllung auf, wobei die reflektierende Umhüllung den Halbleiterchip und stellenweise das Konverterelement an Seitenflächen formschlüssig umhüllt und die erste Oberfläche des Konverterelements frei von der reflektierenden Umhüllung ist.

Das hier beschriebene optoelektronische Halbleiterbauteil beruht dabei unter anderem auf der Erkenntnis, dass ein Austreten der primär im Halbleiterbauteil erzeugten elektromagnetischen Strahlung über Seitenflächen eines Halbleiterchips und Seitenflächen eines dem Halbleiterchip nachgeordneten Konverterelements zu Strahlungsverlusten führt. Es kann zu Verlusten in einer Strahlungseffizienz des Halbleiterbauteils kommen, da die seitlich austretende elektromagnetische Strahlung meist für physikalische und/oder technische Anwendungen nicht nutzbar gemacht werden kann. Mit anderen Worten kann dies zu einer Verringerung der Strahlungseffizienz führen. "Strahlungseffizienz" bedeutet in diesem Zusammenhang das Verhältnis zwischen der jeweils aus dem Halbleiterbauteil ausgekoppelten, nutzbaren Leuchtenergie zu der primär innerhalb des Halbleiterchips erzeugten Leuchtenergie.

Um nun solche unerwünschten Strahlungsverluste zu vermeiden und gleichzeitig die Strahlungseffizienz zu erhöhen, macht das hier beschriebene optoelektronische Halbleiterbauteil unter anderem von der Idee Gebrauch, eine reflektierende Umhüllung bereitzustellen, die den Halbleiterchip und stellenweise das Konverterelement des Halbleiterbauteils an Seitenflächen formschlüssig umhüllt, wobei eine erste Oberfläche des Konverterelements frei von der reflektierenden Umhüllung ist.

Durch die reflektierende Umhüllung wird die innerhalb des Halbleiterchips erzeugte elektromagnetische Strahlung, welche teilweise durch Seitenflächen des Halbleiterchips austritt, zurück in den Halbleiterchip und beispielsweise in Richtung des Konverterelements reflektiert. Vorteilhaft wird so ein möglichst großer Anteil der im Halbleiterchip erzeugten Strahlung in Richtung des Konverterelements geführt. Zumindest ein Teil der aus dem Halbleiterchip über eine Strahlungsauskoppelfläche aus dem Halbleiterchip ausgekoppelten und anschließend in das Konverterelement eingekoppelten Strahlung wird dann zunächst innerhalb des Konverterelements, beispielsweise durch im Konverterelement enthaltene strahlungskonvertierende Partikel, richtungsunabhängig strahlungskonvertiert und dann von diesen reemittiert. "Richtungsunabhängig" bedeutet, dass die im Konverterelement konvertierte elektromagnetische Strahlung innerhalb des Konverterelements von den strahlungskonvertierenden Partikeln in keine Vorzugsrichtung reemittiert wird.

Nach der Konversion der elektromagnetischen Strahlung innerhalb des Konverterelements wird ein Teil der konvertierten Strahlung in Richtung von Seitenflächen des Konverterelements reemittiert und tritt dann über die Seitenflächen des Konverterelements aus dem Konverterelement aus. Dieser Strahlungsanteil trifft anschließend teilweise auf die reflektierende Umhüllung und wird teilweise von dieser in das Konverterelement zurückreflektiert. Zumindest ein Teil dieser in das Konverterelement zurückreflektierten Strahlung wird in Richtung weg vom Halbleiterchip geführt und kann dann aus dem Konverterelement und damit auch aus dem Halbleiterbauteil ausgekoppelt werden. Wird ein Teil der in das Konverterelement zurückreflektierten Strahlung, beispielsweise in Richtung des Halbleiterchips, zurückreflektiert, kann sich der Reflexionsprozess mehrmals wiederholen. Denkbar ist, dass sich der Reflexionsprozess solange wiederholt, bis der entsprechende Strahlungsanteil aus dem Konverterelement auskoppelt. Mit anderen Worten setzt sich die aus dem Halbleiterbauteil ausgekoppelte, nutzbare Strahlung aus dem direkten Strahlungsanteil, also dem Strahlungsanteil, der ohne vorherige Reflexion an der reflektierenden Umhüllung aus dem Halbleiterbauteil ausgekoppelt wird, und dem Strahlungsanteil, der durch zumindest einmalige (Rück-) Reflexion an der Umhüllung das Halbleiterbauteil verlässt, zusammen und wird durch die erste Oberfläche aus dem Halbleiterbauteil ausgekoppelt.

Daher wird ein möglichst großer Anteil der erzeugten Strahlung des Halbleiterchips in Richtung des Konverterelements geführt und über eine erste Oberfläche des Konverterelements aus dem Halbleiterbauteil ausgekoppelt. Vorteilhaft wird mittels der hier beschriebenen Umhüllung sowohl die Strahlungseffizienz des Halbleiterbauteils als auch eine Leuchtdichte an der ersten Oberfläche erhöht, wodurch die erste Oberfläche des Konverterelements für einen externen Betrachter beispielsweise erheblich heller erscheint. "Leuchtdichte" bezeichnet dabei die aus der ersten Oberfläche ausgekoppelte Leuchtenergie im Verhältnis zur Fläche der ersten Oberfläche.

Gemäß zumindest einer Ausführungsform emittiert der strahlungsemittierende Halbleiterchip Licht im blauen bis ultravioletten Bereich des Spektrums der elektromagnetischen Strahlung.

Gemäß zumindest einer Ausführungsform ist die reflektierende Umhüllung mit einem Silikon oder einer Mischung aus einem Silikon oder einem Epoxid gebildet ist, in das strahlungsreflektierende Partikel eingebracht sind, wobei die strahlungsreflektierenden Partikel zumindest aus ZrO₂ bestehen oder zumindest ZrO₂ enthalten. Emittiert der strahlungsemittierende Halbleiterchip blaues oder ultraviolettes Licht weist ZrO₂ in einem derartigen Wellenlängenbereich besonders geringe Absorptionseigenschaften auf. Mit anderen Worten wird in diesem Fall ein hoher Anteil an elektromagnetischer Strahlung von der reflektierenden Umhüllung reflektiert.

Gemäß zumindest einer Ausführungsform ist die reflektierende Umhüllung ein Verguss, dessen Ausdehnung in einer Richtung senkrecht zu den Seitenflächen entlang der Seitenflächen zumindest stellenweise unterschiedlich ist. Mit anderen Worten weist in diesem Fall die reflektierende Umhüllung entlang der Seitenflächen keine gleichmäßige Dicke auf. Es wurde erkannt, dass in einer derartigen Ausformung der reflektierenden Umhüllung diese einen möglichst großen Anteil von auf sie auftreffender elektromagnetischer Strahlung reflektiert.

Ferner ist in diesem Zusammenhang denkbar, dass auf die erste Oberfläche des Konverterelements ein optisches Element, zum Beispiel eine Linse, aufgebracht ist, die den Halbleiterchip in seiner maximalen lateralen Ausdehnung seitlich überragt. Gemäß zumindest einer Ausführungsform ist das Konverterelement mit einem keramischen Material gebildet. Das Konverterelement kann dann ein Lumineszenzkonversionsmaterial aufweisen, das in ein Matrixmaterial, beispielsweise eine Glaskeramik oder eine Keramik, eingebettet ist. Zum Beispiel ist das Konverterelement dann ein Plättchen. Ebenso ist es möglich, dass das Konverterelement vollständig aus einem keramischen Lumineszenzkonversionsmaterial besteht. Das Konverterelement kann dann ein Plättchen aus einem solchen keramischen Lumineszenzkonversionsmaterial sein.

Gemäß zumindest einer Ausführungsform des Halbleiterbauteils weist das Konverterelement eine Dicke in vertikaler Richtung auf, die zumindest doppelt so groß wie die Dicke in vertikaler Richtung des Halbleiterchips ist. Vorteilhaft wird so der Flächenanteil der Seitenflächen des Konverterelements am gesamten Oberflächeninhalt des Konverterelements möglichst groß. Dadurch ist der von der reflektierenden Umhüllung in das Konverterelement zurückreflektierte Strahlungsanteil erhöht, wodurch die Strahlungseffizienz und die Leuchtdichte des Halbleiterbauteils weiter signifikant gesteigert werden.

Gemäß zumindest einer Ausführungsform weist das Konverterelement eine Dicke in vertikaler Richtung von wenigstens 50 µm bis höchstens 500 µm auf. Vorzugsweise weist das Konverterelement eine Dicke in vertikaler Richtung von wenigstens 50 bis höchstens 150 µm auf. Ein solcher Dickenbereich des Konverterelements hat sich als ganz besonders vorteilhaft in Bezug auf die Verringerung von Strahlungsverlusten erwiesen.

Gemäß zumindest einer Ausführungsform treten zumindest 10 % der aus dem Konverterelement austretenden elektromagnetischen Strahlung an den Seitenflächen des Konverterelements aus und werden durch die reflektierende Umhüllung reflektiert. Beläuft sich beispielsweise der Flächeninhalt der Seitenflächen des Konverterelements zum gesamten Oberflächeninhalt des Konverterelements auf 30 %, so können bis zu 30 % der vom Halbleiterchip emittierten elektromagnetischen Strahlung aus dem Konverterelement austreten und durch die reflektierende Umhüllung, zum Beispiel in das Konverterelement, zurückreflektiert werden.

Gemäß zumindest einer Ausführungsform ist die erste Oberfläche des Konverterelements zumindest stellenweise strukturiert. "Strukturiert" heißt in diesem Zusammenhang, dass sich auf der ersten Oberfläche zumindest stellenweise Erhebungen und Senkungen befinden. Die zumindest stellenweise strukturierte Oberfläche kann zum Beispiel mit vorgefertigten, regelmäßigen Strukturen, die kontrolliert in die erste Oberfläche eingebracht sind, gebildet sein. Die Strukturen können relief- oder grabenartig ausgebildet sein. Beispielsweise ist die erste Oberfläche pyramidenförmig strukturiert. Das heißt, dass die erste Oberfläche eine Vielzahl von pyramidenartig ausgebildeten Erhebungen aufweist. Ebenso ist denkbar, dass die erste Oberfläche durch zumindest zwei unterschiedliche sich periodisch entlang der ersten Oberfläche abwechselnden Strukturierungsprofile strukturiert ist. Beispielsweise kann es sich bei dem einen Strukturierungsprofil um pyramidenartige Erhebungen und bei dem anderen Strukturierungsprofil um zylindrische Erhebungen oder um eine zufällige Aufrauung handeln. Es kann gezeigt werden, dass solche strukturierten Oberflächen eine Strahlungseffizienz des Halbleiterbauteils erhöhen.

Gemäß zumindest einer Ausführungsform des Halbleiterbauteils ist zwischen dem Halbleiterchip und dem Konverterelement eine strahlungsdurchlässige Anhaftschicht angeordnet. Der Brechungsindex kann zum Beispiel zwischen dem Brechungsindex des an die Anhaftschicht direkt angrenzenden Materials des Halbleiterchips und dem Brechungsindex des Konverterelements liegen. "Strahlungsdurchlässig" heißt, dass die Anhaftschicht zumindest zu 80 %, bevorzugt zu mindestens 90 %, durchlässig für elektromagnetische Strahlung ist. Beispielsweise ist die Anhaftschicht auf die Strahlungsauskoppelfläche des Halbleiterchips aufgebracht und steht in direktem Kontakt mit der Strahlungsauskoppelfläche und, nach Aufbringung des Konverterelements auf die Anhaftschicht, auch mit einer der ersten Oberfläche des Konverterelements gegenüberliegenden Oberfläche. Mit anderen Worten beabstandet dann die Anhaftschicht den Halbleiterchip und das Konverterelement voneinander. Die Anhaftschicht vermeidet ein Ablösen (auch Delaminieren) des Konverterelements vom Halbleiterchip. Der Halbleiterchip und das Konverterelement sind daher über die Anhaftschicht mechanisch fest miteinander verbunden. Primär im Halbleiterchip erzeugte elektromagnetische Strahlung kann durch die Strahlungsauskoppelfläche aus dem Halbleiterchip durch die Anhaftschicht hindurch treten und in das Konverterelement einkoppeln. Vorteilhaft bietet der für die Anhaftschicht vorgesehene Brechungsindexbereich die Möglichkeit, störende Rückreflexionen in den Halbleiterchip zu vermeiden, wodurch möglichst viel Strahlung in das Konverterelement eingekoppelt wird. Ebenso ist es möglich, dass der Brechungsindex der strahlungsdurchlässigen Anhaftschicht kleiner als der Brechungsindex des an die Anhaftschicht direkt angrenzenden Materials des Halbleiterchips ist. Denkbar ist in diesem Zusammenhang, dass der Brechungsindex der strahlungsdurchlässigen Anhaftschicht zusätzlich kleiner als der Brechungsindex des Konverterelements ist. Beispielsweise liegt der Brechungsindex der strahlungsdurchlässigen Anhaftschicht in einem Bereich von 1,3 bis 1,7, vorzugsweise in einem Bereich von 1,4 bis 1,56. Zum Beispiel ist die Anhaftschicht dann mit einem Silikon, einem Epoxid oder mit einer Mischung der beiden Materialien gebildet. Die genannten Materialien zeigen besonders gute Anhafteigenschaften sowohl an dem Material des Halbleiterchips als auch am Material des Konverterelements.

Gemäß zumindest einer Ausführungsform bedeckt die reflektierende Umhüllung die Seitenflächen des Halbleiterchips und Seitenflächen der Anhaftschicht vollständig. Vorteilhaft wird so ein möglichst großer Anteil der im Halbleiterchip erzeugten elektromagnetischen Strahlung, welcher über Seitenflächen des Halbleiterchips und über die Seitenflächen der Anhaftschicht austritt, durch die reflektierende Umhüllung in den Halbleiterchip und in die Anhaftschicht, beispielsweise in Richtung des Konverterelements, zurückreflektiert.

Gemäß zumindest einer Ausführungsform ist der Halbleiterchip mit seiner dem Konverterelement gegenüberliegenden Fläche auf einem Träger befestigt. Bei dem Träger kann es sich um ein Trägersubstrat handeln, welches von einem Aufwachssubstrat verschieden ist.

Gemäß zumindest einer Ausführungsform ist der Träger mit seiner dem Halbleiterchip gegenüberliegenden Fläche auf einem Bauteilträger angeordnet. Der Bauteilträger kann mit einem Kunststoff, einer Keramik oder einem Metall gebildet sein. Der Bauteilträger ist als eine Leiterplatte oder, falls der Bauteilträger metallisch ist, als ein Trägerrahmen (Leadframe) ausgebildet.

Gemäß zumindest einer Ausführungsform ist die reflektierende Umhüllung mittels eines Jetprozesses aufgebracht. Ebenso ist denkbar, dass die reflektierende Umhüllung mittels eines Moldprozesses, selektivem Abscheidens (zum Beispiel Plasmasprayprozess), Siebdruck, Sputtern oder Sprühen aufgebracht ist.

Gemäß zumindest einer Ausführungsform ist die reflektierende Umhüllung mit einem Silikon oder einer Mischung aus einem Silikon oder einem Epoxid gebildet, in das strahlungsreflektierende Partikel eingebracht sind, wobei die strahlungsreflektierenden Partikel zumindest aus einem der Materialien TiO₂, BaSO₄, ZnO, AlₓO_{y}, ZrO₂ bestehen oder eines der genannten Materialien enthalten.

Gemäß zumindest einer Ausführungsform ist eine Ausdehnung der reflektierenden Umhüllung in einer Richtung senkrecht zu den Seitenflächen größer als 1000 µm. Beispielsweise handelt es sich bei der Richtung senkrecht zu den Seitenflächen um die laterale Richtung.

Bei den Merkmalen, wonach die reflektierende Umhüllung mittels eines Jetprozesses, eines Moldprozesses, selektivem Abscheiden, Siebdruck, Sputtern oder Sprühen aufgebracht ist, handelt es sich jeweils um gegenständliche Merkmale, da die Aufbringungsmethoden direkt im optoelektronischen Halbleiterbauteil nachweisbar sind.

Im Folgenden wird das hier beschriebene Halbleiterbauteil anhand eines Ausführungsbeispiels und der dazugehörigen Figur näher erläutert.
- Die Figur 1: zeigt in einer schematischen Schnittdarstellung ein Ausführungsbeispiel eines hier beschriebenen optoelektronischen Halbleiterbauteils.
- Die Figur 2: zeigt in einer schematischen Schnittdarstellung ein weiteres Ausführungsbeispiel eines hier beschriebenen optoelektronischen Halbleiterbauteils.

In dem Ausführungsbeispiel und der Figur sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

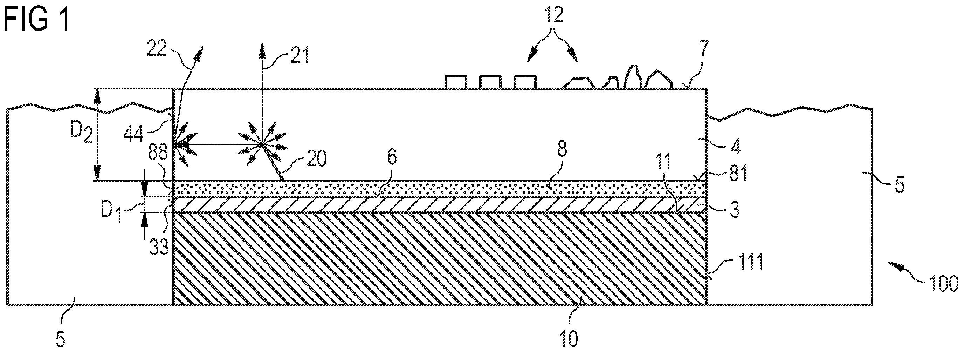

In der Figur 1 ist anhand einer schematischen Schnittdarstellung ein hier beschriebenes optoelektronisches Halbleiterbauteil 100 mit einem Träger 10, einem optoelektronischen Halbleiterchip 3, der auf eine Fläche 11 des Trägers 10 befestigt ist, einer Anhaftschicht 8 und einem Konverterelement 4 gemäß des Ausführungsbeispiels des hier beschriebenen Halbleiterbauteils 100 näher erläutert. In dem Ausführungsbeispiel handelt es sich bei dem Halbleiterchip 3 um einen Dünnfilm-Leuchtdiodenchip, wobei der Träger 10 ein Trägersubstrat ist, welches von einem Aufwachssubstrat verschieden ist. Beispielsweise ist der Träger 10 mit Germanium oder Silizium gebildet. Der Halbleiterchip 3 umfasst dann zum Beispiel eine epitaktisch gewachsene Halbleiterschichtenfolge, die von dem Aufwachssubstrat abgelöst ist.

Auf einer Strahlungsauskoppelfläche 6 des Halbleiterchips 3 ist die Anhaftschicht 8 aufgebracht. Auf einer dem Halbleiterchip 3 gegenüberliegenden Fläche 81 der Anhaftschicht 8 ist das Konverterelement 4 aufgebracht, das mit einem keramischen Material gebildet ist, in welches beispielsweise strahlungskonvertierende Materialien, zum Beispiel Partikel und/oder Fasern, eingebracht sind. Das Konverterelement 4 weist ein Dicke D₂ von 200 µm auf, wobei die Dicke D₁ des Halbleiterchips 3 100 µm beträgt.

Im vorliegenden Ausführungsbeispiel stehen die Anhaftschicht 8 und das Konverterelement 4 in direktem Kontakt, sodass sich zwischen dem Konverterelement 4 und der Anhaftschicht 8 weder ein Spalt noch eine Unterbrechung ausbildet. Um ein Ablösen des Konverterelements 4 vom Halbleiterchip 3 zu vermeiden, ermöglicht die Anhaftschicht 8, dass das Konverterelement 4 und der Halbleiterchip 3 mechanisch fest über die Anhaftschicht 8 miteinander verbunden sind. Die Anhaftschicht 8 ist mit einem Silikon gebildet.

Eine reflektierende Umhüllung 5 bedeckt Seitenflächen 33 des Halbleiterchips 3, Seitenflächen 88 der Anhaftschicht 8 und Seitenflächen 111 des Trägers 10 vollständig sowie stellenweise Seitenflächen 44 des Konverterelements 4.

Vorliegend ist die reflektierende Umhüllung 5 als ein Verguss ausgebildet. Erkennbar ist, dass für einen externen Betrachter der Halbleiterchip 3 vollständig von der reflektierenden Umhüllung 5 verdeckt ist, wobei das Konverterelement 4 aus der reflektierenden Umhüllung noch herausragt. Eine Ausdehnung der reflektierenden Umhüllung in einer Richtung senkrecht zu den Seitenflächen, beispielsweise in lateraler Richtung, kann insbesondere größer als 1000 µm sein.

Die reflektierende Umhüllung 5 kann mit einem Silikon gebildet sein, in das strahlungsreflektierende Materialien, zum Beispiel Partikel und/oder Fasern, eingebracht sind. Eine mit einem solchen Material gebildete reflektierende Umhüllung 5 ist ganz besonders alterungsstabil. Beispielsweise haben Silikone den Vorteil, bei Einstrahlung von elektromagnetischer Strahlung deutlich geringer als andere Umhüllungsmassen, beispielsweise Harze, zu altern. Ferner weisen Silikone eine erheblich gesteigerte Temperaturbeständigkeit als zum Beispiel Epoxide auf. Während Epoxide typischerweise bis maximal etwa 150° C erhitzt werden können, ohne Schaden zu nehmen, ist dies bei Silikonen bis etwa 200° C möglich. Ebenso ist denkbar, dass die reflektierende Umhüllung 5 mit einem Hybridmaterial, beispielsweise einer Mischung aus einem Silikon und einem Epoxid, gebildet ist.

Beispielsweise handelt es sich bei den strahlungsreflektierenden Partikeln um Partikel, die aus zumindest einem der Materialien TiO₂, BaSO₄, ZnO, AlₓO_{y}, ZrO₂ bestehen oder eines der genannten Materialien enthalten. Falls der optoelektronischen Halbleiterchip 3 blaues Licht und/oder elektromagnetische Strahlung im ultravioleten Spektralbereich des Spektrums elektromagnetischer Strahlung emittiert kann insbesondere ZrO₂ als Material für die strahlungsreflektierenden Partikel Verwendung finden, da in einem derartigen Wellenlängenbereich ZrO₂ besonders geringe Absorptionseigenschaften aufweist. Mit anderen Worten wird in diesem Fall ein hoher Anteil an elektromagnetischer Strahlung von der reflektierenden Umhüllung 5 reflektiert.

Vorzugsweise beträgt die Konzentration der strahlungsstreuenden Partikel in der reflektierenden Umhüllung 5 10 bis 40 Gew-%. Vorzugsweise beträgt die Konzentration 15 bis 30 Gew-%. Beispielsweise kann das Reflexionsvermögen der reflektierenden Umhüllung 5 in Abhängigkeit der Konzentration der strahlungsstreuenden Partikel individuell eingestellt werden. Für einen externen Betrachter erscheint die reflektierende Umhüllung 5 aufgrund der Reflexionseigenschaften in einem Weiß-Ton, da von der reflektierenden Umhüllung vorzugsweise das gesamte auftreffende Farbspektrum reflektiert wird. Der Weiß-Ton der Umhüllung kann den Farbkontrast zwischen der aus einer ersten Oberfläche 7 des Konverterelements 4 ausgekoppelten elektromagnetischen Strahlung und der reflektierenden Umhüllung 5 verringern, sodass das gesamte Halbleiterbauteil 100 für einen externen Betrachter über seine gesamte laterale Ausdehnung in einem möglichst gleichmäßigen Farbton erscheint.

Die in das Konverterelement 4 eingekoppelte Strahlung 20 wird im Konverterelement 4 zumindest teilweise konvertiert und dann richtungsunabhängig innerhalb des Konverterelements 4 reemittiert. In dem Ausführungsbeispiel treten 30 % der aus dem Konverterelement 4 austretenden elektromagnetischen Strahlung aus den Seitenflächen 44 des Konverterelements 4 aus. Nach dem Austreten aus dem Konverterelement 4 wird die elektromagnetische Strahlung teilweise durch die reflektierende Umhüllung 5 in das Konverterelement 4 in Richtung der ersten Oberfläche 7, also weg vom Halbleiterchip 3, zurückreflektiert.

Die aus dem Konverterelement 4 durch die erste Oberfläche 7 ausgekoppelte Strahlung 20 setzt sich daher aus einem reflektierten Strahlungsanteil 22 und einem Strahlungsanteil 21 zusammen, der ohne von der reflektierenden Umhüllung 5 reflektiert worden zu sein aus dem Halbleiterbauteil 100 austritt.

Da in vorliegendem Ausführungsbeispiel die reflektierende Umhüllung 5 ebenso die Seitenflächen 111 des Trägers 10 vollständig bedeckt, wird vermieden, dass Strahlung, die das optoelektronische Halbleiterbauteil 100 bereits verlassen hat, beispielsweise über die Seitenflächen 111 des Trägers 10, wieder reabsorbiert wird.

Ferner ist die erste Oberfläche 7 des Konverterelements 4 zumindest stellenweise strukturiert. Mit anderen Worten weist die erste Oberfläche 7 zumindest stellenweise Auskoppelstrukturen 12 auf. Die von dem Halbleiterchip 3 erzeugte elektromagnetische Strahlung wird über die zumindest stellenweise strukturierte erste Oberfläche 7 aus dem Halbleiterbauteil 100 ausgekoppelt. Es kann gezeigt werden, dass derartige Auskoppelstrukturen 12 die Strahlungseffizienz deutlich erhöhen.

Das heißt, dass sich in dem in Figur 1 gezeigten Ausführungsbeispiel die Strahlungseffizienz zum einen durch die hier beschriebene reflektierende Umhüllung 5 und zum anderen durch die Auskoppelstrukturen 12 erhöht, wobei sich vorteilhaft beide Effekte ergänzen können.

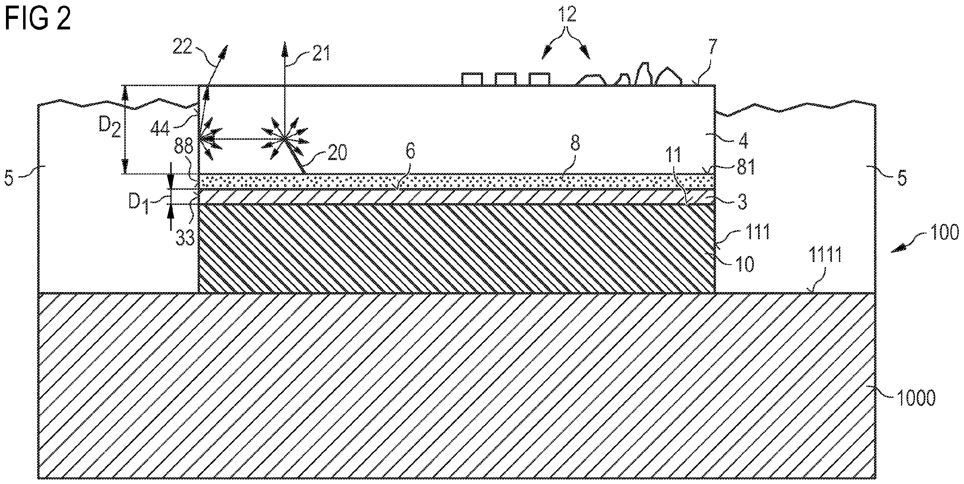

In der Figur 2 ist der Träger 10 mit seiner dem Halbleiterchip 3 gegenüberliegenden Fläche auf einem Bauteilträger 1000 angeordnet. Vorliegend ist der Bauteilträger 1000 ein metallischer Trägerrahmen, auf dessen Oberfläche zumindest stellenweise eine Goldschicht aufgebracht ist. Die reflektierende Umhüllung 5 bedeckt Seitenflächen 33 des Halbleiterchips 3, Seitenflächen 88 der Anhaftschicht 8 und Seitenflächen 111 des Trägers 10 vollständig sowie stellenweise Seitenflächen 44 des Konverterelements 4. Ferner bedeckt die reflektierende Umhüllung 5 vom Träger 10 nicht bedeckte Stellen einer Fläche 1111 des Bauteilträgers 1000 zumindest stellenweise.

Wird elektromagnetische Strahlung, die das optoelektronische Halbleiterbauteil 100 bereits verlassen hat, beispielsweise durch eine dem optoelektronischen Halbleiterbauteil 100 in einer Abstrahlrichtung des Halbleiterbauteils 100 nachgeordnete Optik, zurück in Richtung des Bauteilträgers 1000 abgelenkt, so wird ein möglicht großer Strahlungsanteil von der reflektierenden Umhüllung 5 in Richtung weg vom Bauteilträger 1000 wieder zurück reflektiert. Mit anderen Worten wird durch die reflektierende Umhüllung 5 das Reflexionsvermögen der Goldoberfläche des Bauteilträgers 1000 erhöht.

Ebenso zeigt sich bei einem mit Silber gebildeten oder mit Silber beschichteten Bauteilträger 1000 eine durch die reflektierende Umhüllung 5 hervorgerufene erhöhte Reflektivität. Zusätzlich bietet die reflektierende Umhüllung 5 Schutz vor Umwelteinflüssen, wodurch beispielsweise Korrosion des Bauteilträgers 1000, zum Beispiel des Silbers, vermieden wird.

Die Erfindung ist nicht durch die Beschreibung anhand des Ausführungsbeispiels beschränkt. Vielmehr erfasst die Erfindung jedes neue Merkmal sowie die Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder dem Ausführungsbeispiel angegeben ist.

## Patentansprüche

1. Optoelektronisches Halbleiterbauteil (100),
aufweisend
- zumindest einen strahlungsemittierenden Halbleiterchip (3) mit einer Strahlungsauskoppelfläche (6), durch die zumindest ein Teil der im Halbleiterchip (3) erzeugten elektromagnetischen Strahlung den Halbleiterchip (3) verlässt;
- zumindest ein Konverterelement (4), das dem Halbleiterchip (3) an seiner Strahlungsauskoppelfläche (6) zur Konversion von vom Halbleiterchip (3) emittierter elektromagnetischer Strahlung nachgeordnet ist und eine der Strahlungsauskoppelfläche (6) abgewandte erste Oberfläche (7) aufweist;
- eine reflektierende Umhüllung (5), wobei
- die reflektierende Umhüllung (5) den Halbleiterchip (3) und stellenweise das Konverterelement an Seitenflächen (33, 44) formschlüssig umhüllt,
- die erste Oberfläche (7) des Konverterelements (4) frei von der reflektierenden Umhüllung (5) ist,
- eine Ausdehnung der reflektierenden Umhüllung (5) in einer Richtung senkrecht zu den Seitenflächen (33, 44) größer als 1000 µm ist, und
- das Konverterelement (4) aus der reflektierenden Umhüllung herausragt.

2. Optoelektronisches Halbleiterbauteil (100) nach dem vorhergehenden Anspruch, bei dem
- der strahlungsemittierende Halbleiterchip (3) Licht im blauen bis ultravioletten Bereich des Spektrums der elektromagnetischen Strahlung emittiert,
- die reflektierende Umhüllung (5) mit einem Silikon oder einer Mischung aus einem Silikon oder einem Epoxid gebildet ist, in das strahlungsreflektierende Partikel eingebracht sind, wobei die strahlungsreflektierenden Partikel zumindest aus ZrO₂ bestehen oder zumindest ZrO₂ enthalten, und
- die reflektierende Umhüllung (5) ein Verguss ist, dessen Ausdehnung in einer Richtung senkrecht zu den Seitenflächen (33, 44) entlang der Seitenflächen (33, 44) zumindest stellenweise unterschiedlich ist.

3. Optoelektronisches Halbleiterbauteil (100) nach einem der vorhergehenden Ansprüche,
bei dem die erste Oberfläche (7) des Konverterelements (4) zumindest stellenweise strukturiert ist.

4. Optoelektronisches Halbleiterbauteil (100) nach einem der vorhergehenden Ansprüche,
bei dem das Konverterelement (4) mit einem keramischen Material gebildet ist.

5. Optoelektronisches Halbleiterbauteil (100) nach einem der vorhergehenden Ansprüche,
bei dem das Konverterelement (4) eine Dicke in vertikaler Richtung aufweist, die zumindest doppelt so groß wie die Dicke in vertikaler Richtung des Halbleiterchips (3) ist.

6. Optoelektronisches Halbleiterbauteil (100) nach einem der vorhergehenden Ansprüche,
bei dem das Konverterelement (4) eine Dicke in vertikaler Richtung von wenigstens 50 µm bis höchstens 500 µm aufweist.

7. Optoelektronisches Halbleiterbauteil (100) nach einem der vorhergehenden Ansprüche,
bei dem zumindest 10 % der aus dem Konverterelement (4) austretenden elektromagnetischen Strahlung an den Seitenflächen (44) des Konverterelements (4) austreten und durch die reflektierende Umhüllung (5) reflektiert werden.

8. Optoelektronisches Halbleiterbauteil (100) nach einem der vorhergehenden Ansprüche,
bei dem sich auf der ersten Oberfläche (7) des Konverterelements (4) zumindest stellenweise Erhebungen und Senkungen befinden.

9. Optoelektronisches Halbleiterbauteil (100) nach einem der vorhergehenden Ansprüche,
bei dem zwischen dem Halbleiterchip (3) und dem Konverterelement (4) eine strahlungsdurchlässige Anhaftschicht (8) angeordnet ist.

10. Optoelektronisches Halbleiterbauteil (100) nach Anspruch 9,
bei dem die reflektierende Umhüllung (5) die Seitenflächen (33) des Halbleiterchips (3) und Seitenflächen (88) der Anhaftschicht (8) vollständig bedeckt.

11. Optoelektronisches Halbleiterbauteil (100) nach einem der vorhergehenden Ansprüche,
bei dem die reflektierende Umhüllung (5) mittels eines Jet-Prozesses aufgebracht ist.

12. Optoelektronisches Halbleiterbauteil (100) nach einem der vorhergehenden Ansprüche,
bei dem die reflektierende Umhüllung (5) mit einem Silikon oder einer Mischung aus einem Silikon oder einem Epoxid gebildet ist, in das strahlungsreflektierende Partikel eingebracht sind, wobei die strahlungsreflektierenden Partikel zumindest aus einem der Materialien TiO₂, BaSO₄, ZnO, AlₓO_{y}, ZrO₂ bestehen oder eines der genannten Materialien enthalten.

13. Optoelektronisches Halbleiterbauteil (100) nach einem der vorhergehenden Ansprüche, bei dem auf die erste Oberfläche (7) des Konverterelements (4) eine Linse aufgebracht ist, die den Halbleiterchip (3) in seiner maximalen lateralen Ausdehnung seitlich überragt.

14. Optoelektronisches Halbleiterbauteil (100) nach einem der vorhergehenden Ansprüche, bei dem die reflektierende Umhüllung (5) ein Verguss ist, dessen Ausdehnung in einer Richtung senkrecht zu den Seitenflächen (33, 44) entlang der Seitenflächen (33, 44) zumindest stellenweise unterschiedlich ist.

## Claims

1. Optoelectronic semiconductor component (100), comprising
- at least one radiation-emitting semiconductor chip (3) having a radiation coupling-out surface (6), through which at least part of the electromagnetic radiation generated in the semiconductor chip (3) leaves the semiconductor chip (3);
- at least one converter element (4) which is disposed downstream of the semiconductor chip (3) at its radiation coupling-out surface (6) for the conversion of electromagnetic radiation emitted by the semiconductor chip (3) and has a first surface (7) facing away from the radiation coupling-out surface (6);
- a reflective encapsulation (5), wherein
- the reflective encapsulation (5) encapsulates the semiconductor chip (3) and at least in places the converter element at side surfaces (33, 44) in a form-fitting manner, and
- the first surface (7) of the converter element (4) is free of the reflective encapsulation (5)
- an extent of the reflective encapsulation (5) in a direction perpendicular to the side surfaces (33, 44) is greater than 1000 µm, and
- the converter element (4) projects from the reflective encapsulation.

2. Optoelectronic semiconductor component (100) according to the preceding claim, in which
- the radiation-emitting semiconductor chip (3) emits light in the blue to ultraviolet range of the spectrum of the electromagnetic radiation,
- the reflective encapsulation (5) is formed with a silicone or a mixture of a silicone or an epoxide, into which radiation-reflecting particles are introduced, wherein the radiation-reflecting particles at least consist of ZrO₂ or at least contain ZrO₂, and
- the reflective encapsulation (5) is a potting, the extent of which in a direction perpendicular to the side surfaces (33, 44) is different at least in places along the side surfaces (33, 44).

3. Optoelectronic semiconductor component (100) according to any of the preceding claims,
in which the first surface (7) of the converter element (4) is structured at least in places.

4. Optoelectronic semiconductor component (100) according to any of the preceding claims,
in which the converter element (4) is formed with a ceramic material.

5. Optoelectronic semiconductor component (100) according to any of the preceding claims,
in which the converter element (4) has a thickness in a vertical direction, which is at least double the magnitude of the thickness in a vertical direction of the semiconductor chip (3).

6. Optoelectronic semiconductor component (100) according to any of the preceding claims,
in which the converter element (4) has a thickness in a vertical direction of at least 50 µm to at most 500 µm.

7. Optoelectronic semiconductor component (100) according to any of the preceding claims,
in which at least 10% of the electromagnetic radiation emerging from the converter element (4) emerges at the side surfaces (44) of the converter element (4) and is reflected by the reflective encapsulation (5).

8. Optoelectronic semiconductor component (100) according to any of the preceding claims,
in which elevations and depressions are situated on the first surface (7) of the converter element (4) at least in places.

9. Optoelectronic semiconductor component (100) according to any of the preceding claims,
in which a radiation-transmissive adhesion layer (8) is arranged between the semiconductor chip (3) and the converter element (4).

10. Optoelectronic semiconductor component (100) according to claim 9,
in which the reflective encapsulation (5) completely covers the side surfaces (33) of the semiconductor chip (3) and side surfaces (88) of the adhesion layer (8).

11. Optoelectronic semiconductor component (100) according to any of the preceding claims,
in which the reflective encapsulation (5) is applied by means of a jet process.

12. Optoelectronic semiconductor component (100) according to any of the preceding claims,
in which the reflective encapsulation (5) is formed with a silicone or a mixture of a silicone or an epoxide, into which radiation-reflecting particles are introduced, wherein the radiation-reflecting particles at least consist of one of the materials TiO₂, BaSO₄, ZnO, AlₓO_{y}, ZrO₂ or contain one of the materials mentioned.

13. Optoelectronic semiconductor component (100) according to any of the preceding claims, in which a lens is applied to the first surface (7) of the converter element (4), which laterally projects beyond the semiconductor chip (3) in its maximum lateral extent.

14. Optoelectronic semiconductor component (100) according to any of the preceding claims, in which the reflective encapsulation (5) is a potting, the extent of which in a direction perpendicular to the side areas (33, 44) is different at least in places along the side areas (33, 44) .

## Revendications

1. Composant semi-conducteur optoélectronique (100), comprenant:
- au moins une puce semi-conductrice émettrice de rayonnement (3) comportant une surface de découplage de rayonnement (6) à travers laquelle au moins une partie du rayonnement électromagnétique généré dans la puce semi-conductrice (3) quitte la puce semi-conductrice (3) ;
- au moins un élément convertisseur (4) disposé en aval de la puce semi-conductrice (3) au niveau de sa surface de découplage de rayonnement (6) pour la conversion du rayonnement électromagnétique émis par la puce semi-conductrice (3) et comportant une première surface (7) détournée de la surface de découplage de rayonnement (6) ;
- un enrobage réfléchissant (5), dans lequel
- l'enrobage réfléchissant (5) entoure de manière positive la puce semi-conductrice (3) et au moins par endroits l'élément convertisseur au droit de surfaces latérales (33, 44),
- la première surface (7) de l'élément convertisseur (4) est exempte de l'enrobage réfléchissant (5),
- une extension de l'enrobage réfléchissant (5) est supérieure à 1000 µm dans une direction perpendiculaire aux surfaces latérales (33, 44), et
- l'élément convertisseur (4) fait saillie de l'enrobage réfléchissant.

2. Composant semi-conducteur optoélectronique (100) selon la revendication précédente, dans lequel
- la puce semi-conductrice émettrice de rayonnement (3) émet de la lumière dans le domaine bleu à ultraviolet du spectre du rayonnement électromagnétique,
- l'enrobage réfléchissant (5) est réalisé grâce à une silicone ou à un mélange d'une silicone ou d'un époxyde, dans lequel des particules réfléchissant le rayonnement sont incorporées, les particules réfléchissant le rayonnement consistant au moins en ZrO2 ou contenant au moins du ZrO2, et
- l'enrobage réfléchissant (5) est un scellement dont l'extension dans une direction perpendiculaire aux surfaces latérales (33, 44) le long des surfaces latérales (33, 44) est différente au moins par endroits.

3. Composant semi-conducteur optoélectronique (100) selon l'une des revendications précédentes, dans lequel la première surface (7) de l'élément convertisseur (4) est structurée au moins par endroits.

4. Composant semi-conducteur optoélectronique (100) selon l'une des revendications précédentes, dans lequel l'élément convertisseur (4) est constitué par un matériau céramique.

5. Composant semi-conducteur optoélectronique (100) selon l'une des revendications précédentes, dans lequel l'élément de convertisseur (4) présente une épaisseur en direction verticale qui est au moins le double de l'épaisseur en direction verticale de la puce semi-conductrice (3).

6. Composant semi-conducteur optoélectronique (100) selon l'une des revendications précédentes, dans lequel l'élément convertisseur (4) présente une épaisseur en direction verticale comprise entre 50 µm au minimum et 500 µm au maximum.

7. Composant semi-conducteur optoélectronique (100) selon l'une des revendications précédentes, dans lequel au moins 10% du rayonnement électromagnétique sortant de l'élément convertisseur (4) sortent aux surfaces latérales (44) de l'élément convertisseur (4) et sont réfléchis par l'enrobage réfléchissant (5).

8. Composant semi-conducteur optoélectronique (100) selon l'une des revendications précédentes, dans lequel,
sur la première surface (7) de l'élément convertisseur (4), il y a des élévations et des dépressions au moins par endroits.

9. Composant semi-conducteur optoélectronique (100) selon l'une des revendications précédentes, dans lequel une couche adhésive (8) perméable au rayonnement est disposée entre la puce semi-conductrice (3) et l'élément convertisseur (4).

10. Composant semi-conducteur optoélectronique (100) selon revendication 9, dans lequel
l'enrobage réfléchissant (5) recouvre entièrement les surfaces latérales (33) de la puce semi-conductrice (3) et les surfaces latérales (88) de la couche adhésive (8).

11. Composant semi-conducteur optoélectronique (100) selon l'une des revendications précédentes, dans lequel l'enrobage réfléchissant (5) est déposé au moyen d'un procédé à jet.

12. Composant semi-conducteur optoélectronique (100) selon l'une des revendications précédentes, dans lequel l'enrobage réfléchissant (5) est réalisé grâce à une silicone ou à un mélange d'une silicone ou d'un époxyde dans lequel des particules réfléchissant le rayonnement sont incorporées, les particules réfléchissant le rayonnement consistant au moins en une matière choisie dans le groupe comprenant les TiO₂, BaSO₄, ZnO, AlxOy, ZrO2 ou contenant une des matières susmentionnées.

13. Composant semi-conducteur optoélectronique (100) selon l'une des revendications précédentes, dans lequel,
sur la première surface (7) de l'élément convertisseur (4), une lentille est appliquée qui surmonte latéralement la puce semi-conductrice (3) dans son extension latérale maximale.

14. Composant semi-conducteur optoélectronique (100) selon l'une des revendications précédentes, dans lequel l'enrobage réfléchissant (5) est un scellement dont l'extension dans une direction verticalement aux surfaces latérales (33, 44) le long des surfaces latérales (33, 44) est différente au moins par endroits.
